(19)

Europäisches
Patentamt

European
Patent Office

Office européen
des brevets

(11) **EP 1 217 707 B1**

(12) **FASCICULE DE BREVET EUROPEEN**

(45) Date de publication et mention
de la délivrance du brevet:
**08.09.2010   Bulletin 2010/36**

(21) Numéro de dépôt: **01410121.6**

(22) Date de dépôt: **25.09.2001**

(51) Int Cl.:
***H02H 1/00*** *(2006.01)*

(54) **Dispositif de détermination du courant primaire d'un transformateur de courant comportant des moyens de correction de saturation**

Verfahren zur Bestimmung eines Primärstroms für Stromwandler mit Sättigungskorrekturmitteln

Device for termination of primary current in a current transformer having saturation compensation means

(84) Etats contractants désignés:
**DE GB IT**

(30) Priorité:  **20.12.2000   FR 0016640**

(43) Date de publication de la demande:
**26.06.2002   Bulletin 2002/26**

(73) Titulaire: **Schneider Electric Industries SAS
92500 Rueil-Malmaison (FR)**

(72) Inventeurs:
 • **Clausse, Christine
  38050 Grenoble cedex 09 (FR)**
 • **Leprettre, Benoît
  38050 Grenoble cedex 09 (FR)**
 • **Pouillot, Marc
  38050 Grenoble cedex 09 (FR)**
 • **Pianu, Paul
  38050 Grenoble cedex 09 (FR)**

(74) Mandataire: **Tripodi, Paul et al
Schneider Electric Industries SAS
Service Propriété Industrielle
World Trade Center - E1
5 Place Robert Schuman
38050 Grenoble Cedex 9 (FR)**

(56) Documents cités:
**WO-A-93/13581**

EP 1 217 707 B1

## Description

L'invention concerne un dispositif de détermination du courant primaire d'un transformateur de courant, comportant des moyens de traitement numérique ayant une première entrée recevant des valeurs instantanées mesurées du courant secondaire du transformateur et une sortie fournissant les valeurs instantanées du courant primaire associé, corrigées en cas de saturation du transformateur.

De nombreux dispositifs, notamment les déclencheurs des disjoncteurs électriques, utilisent des transformateurs de courant pour mesurer le courant électrique dans un conducteur, que ce soit dans un but de mesure ou de protection. Les problèmes de saturation du circuit magnétique d'un transformateur de courant obligent soit à surdimensioner le transformateur, ce qui pose des problèmes de volume et de coût, soit à tenter de corriger les effets dus à la saturation.

Un certain nombre de méthodes de traitement numérique du courant secondaire, éventuellement déformé, parcourant un enroulement secondaire d'un transformateur de courant ont été proposées. Le document WO-A-9313581, par exemple, décrit un dispositif permettant d'obtenir des courants primaire et secondaire corrigés, à partir d'échantillons de courant secondaire mesuré, en utilisant au moins un modèle de transformateur de courant saturé et un modèle de transformateur de courant non saturé, ainsi qu'un modèle des signaux de courant primaire. Plus récemment, le document EP-A-980129 a préconisé l'utilisation de réseaux de neurones réalisant une fonction de transfert inverse d'un transformateur de courant tenant compte des effets de la saturation éventuelle de celui-ci. Le réseau de neurones reçoit en entrée le courant secondaire, éventuellement déformé, parcourant l'enroulement secondaire du transformateur de courant et fournit en sortie une valeur représentative du courant à mesurer correspondant parcourant le primaire du transformateur.

En pratique, les dispositifs connus ne fonctionnent correctement que si le courant à mesurer est parfaitement sinusoïdal. Par ailleurs, le courant secondaire dépendant fortement de la charge branchée sur le secondaire du transformateur, le transformateur de courant ne peut être utilisé pour alimenter les composants électroniques du dispositif.

L'invention a pour but de remédier à ces inconvénients et de fournir un dispositif permettant une détermination précise du courant primaire, même en cas de saturation du transformateur, quelle que soit la forme du courant, tout en tolérant d'importantes variations de charge au secondaire du transformateur.

Selon l'invention, ce but est atteint par le fait que les moyens de traitement numérique comportent une seconde entrée recevant une tension secondaire mesurée aux bornes d'un enroulement secondaire du transformateur de courant et connectée à l'entrée de moyens intégrateurs fournissant des signaux représentatifs du flux magnétique instantané dans le secondaire du transformateur, des moyens de modélisation, représentatifs d'un modèle inverse du transformateur de courant et comportant des première et seconde entrées et une sortie, la première entrée des moyens de modélisation étant connectée à la première entrée des moyens de traitement numérique , la seconde entrée des moyens de modélisation étant connectée à la sortie des moyens intégrateurs et la sortie des moyens de modélisation étant connectée à la sortie des moyens de traitement numérique.

Les moyens de modélisation sont, de préférence, constitués par une table numérique à deux entrées. Le dispositif selon l'invention n'exige pas, dans ce cas, de disposer d'une grande puissance de calcul, contrairement aux dispositifs antérieurs.

Selon un premier développement de l'invention le transformateur comporte un premier enroulement secondaire, fournissant les valeurs instantanées du courant secondaire, et un second enroulement secondaire, ouvert, disposé autour du premier enroulement secondaire et fournissant la tension secondaire appliquée à la seconde entrée des moyens de traitement.

Selon un second développement de l'invention le transformateur comporte un enroulement secondaire fournissant les valeurs instantanées du courant secondaire et de la tension secondaire, les moyens de traitement numérique comportant des moyens multiplicateurs connectés à la première entrée des moyens numériques de traitement pour multiplier le courant secondaire par une grandeur représentative de la résistance du secondaire du transformateur de courant, des moyens sommateurs connectés à la sortie des moyens multiplicateurs et à la seconde entrée des moyens de traitement numérique, la sortie des moyens sommateurs étant connectée à l'entrée des moyens intégrateurs.

D'autres avantages et caractéristiques ressortiront plus clairement de la description suivante de modes particuliers de réalisation, donnés à titre d'exemple non limitatifs et représentés sur les dessins annexés dans lesquels :

La figure 1 représente un schéma électrique d'un transformateur de courant.

La figure 2 représente un schéma équivalent du transformateur selon la figure 1.

Les figures 3 et 4 représentent respectivement des schémas de modélisation directe et inverse d'un transformateur de courant.

La figure 5 illustre un premier mode de réalisation d'un dispositif selon l'invention.

La figure 6 représente le schéma électrique d'un transformateur de courant, comportant deux enroulements secondaires.

La figure 7 illustre un schéma de modélisation inverse d'un transformateur de courant selon la figure 6.

La figure 8 représente un second mode de réalisation d'un dispositif selon l'invention utilisé avec un transformateur de courant selon la figure 6.

La figure 9 représente plus en détail un mode de réalisation particulier d'un bloc intégrateur d'un dispositif selon l'invention, comportant des moyens de stabilisation.

La figure 10 représente plus en détail un mode de réalisation particulier d'un circuit régulateur du bloc intégrateur selon la figure 9.

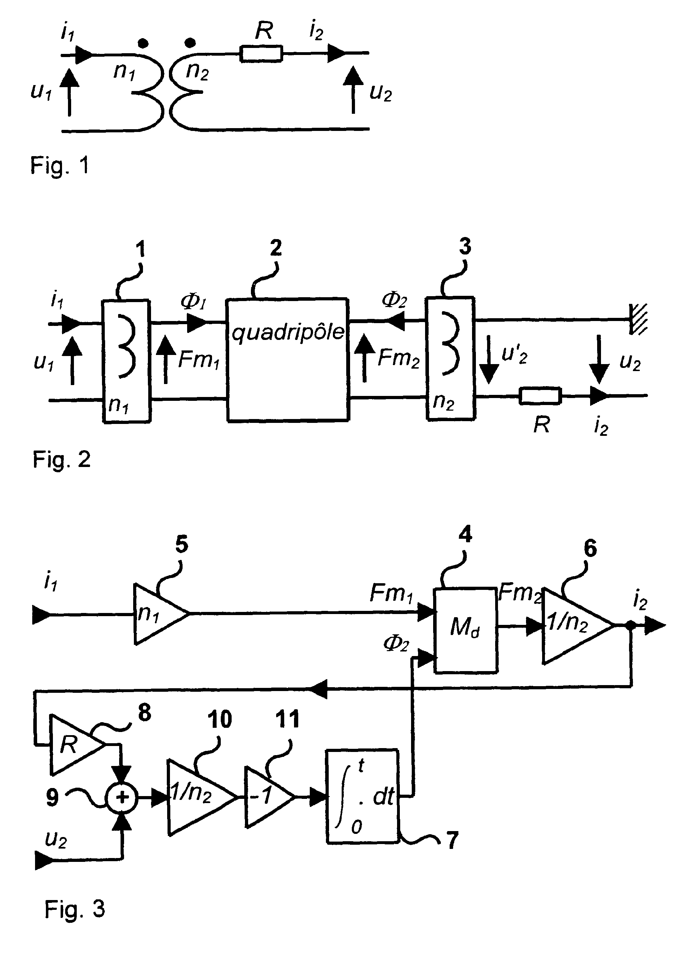

Le transformateur selon la figure 1 comporte, de manière classique, un enroulement primaire, comportant $n_1$ spires, parcouru par un courant primaire $i_1$. Une tension primaire $u_1$ est développée à ses bornes. L'enroulement primaire est couplé magnétiquement par un noyau magnétique, éventuellement avec des entrefers, non représenté, à un enroulement secondaire, ayant une résistance R et comportant $n_2$ spires. L'enroulement secondaire est parcouru par un courant $i_2$ et développe à ses bornes une tension secondaire $u_2$.

Selon la figure 2, le fonctionnement du transformateur selon la figure 1 peut être représenté sous la forme d'un modèle constitué par un quadripôle d'entrée 1, représentant l'enroulement primaire considéré comme idéal, connecté en série avec un quadripôle 2, représentant l'ensemble constitué par le noyau magnétique et les entrefers du transformateurs, avec un quadripôle de sortie 3, représentant l'enroulement secondaire considéré comme idéal, et avec la résistance R de l'enroulement secondaire.

Les signaux d'entrée du quadripôle 1 sont des signaux électriques constitués par le courant primaire $i_1$ et la tension primaire $u_1$. Les signaux de sortie du quadripôle d'entrée 1, qui constituent les signaux d'entrée du quadripôle 2, sont des grandeurs magnétiques constitués par le flux magnétique $\varnothing_1$ traversant l'enroulement primaire et par la force magnétomotrice $Fm_1$ associée à l'enroulement primaire. De manière connue, les relations entre les signaux électriques d'entrée et les grandeurs magnétiques de sortie du quadripôle d'entrée 1 sont données par :

$$Fm_1 = n_1\, i_1$$

$$u_1 = n_1\, d\, \varnothing_1/dt$$

De manière analogue, les signaux de sortie du quadripôle 2, qui constituent les signaux d'entrée du quadripôle de sortie 3, sont constitués par le flux magnétique $\varnothing_2$ traversant l'enroulement secondaire et la force magnétomotrice $Fm_2$ associée à l'enroulement secondaire. Les signaux de sortie du quadripôle de sortie 3 sont constitués par le courant secondaire $i_2$ et par une tension secondaire intermédiaire $u'_2$, qui serait présente aux bornes d'un enroulement secondaire de résistance nulle. Les relations entre les grandeurs magnétiques d'entrée et les signaux électriques de sortie du dipôle de sortie 3 sont données par :

$$Fm_2 = n_2\, i_2$$

$$u'_2 = - n_2\, d\, \varnothing_2/dt$$

avec $u'_2 = u_2 + Ri_2$, pour tenir compte de la résistance non nulle de l'enroulement secondaire.

Le quadripôle 2 est formé de dipôles statiques et il existe une fonction $Fm_2\,(\varnothing_2, Fm_1)$ unique. La fonction $Fm_2\,(\varnothing_2, Fm_1)$, peut être tabulée sous forme d'une nappe à deux entrées et une sortie, caractérisant entièrement le quadripôle 2, c'est-à-dire le circuit magnétique du transformateur avec ses non-linéarités et ses fuites. Les courbes caractéristiques des dipôles qui composent le quadripôle (entrefers, fer) étant toutes symétriques par rapport à zéro, la nappe est symétrique par rapport à l'origine. Ceci permet de réduire par deux la mémoire nécessaire à son stockage.

On peut passer de la figure 2 à un schéma de modélisation directe d'un transformateur de courant illustré à la figure 3 sous forme de schéma-bloc. Une première entrée d'un bloc 4, représentatif d'un modèle direct (Md) de transformateur, est connectée à une première entrée du schéma de modélisation directe, recevant des signaux représentatifs du courant primaire $i_1$, par l'intermédiaire d'un premier bloc multiplicateur 5, représenté sous la forme d'un bloc amplificateur de gain $n_1$ et fournissant une grandeur représentative de la force magnétomotrice $Fm_1$. La sortie du bloc 4, représentative de la force magnétomotrice $Fm_2$, est connectée à la sortie du schéma de modélisation directe, fournissant des signaux représentatifs du courant secondaire $i_2$, par l'intermédiaire d'un second bloc multiplicateur 6, représenté sous la forme d'un bloc amplificateur, de gain $1/n_2$. Une seconde entrée du bloc 4 est connectée à la sortie d'un bloc intégrateur 7. La sortie du second bloc multiplicateur 6 est connectée à l'entrée d'un troisième bloc multiplicateur 8, représenté sous la forme d'un bloc amplificateur, de gain R. Un bloc sommateur 9 est connecté respectivement à la sortie du troisième bloc multiplicateur 8 et à une seconde entrée du schéma de modélisation directe, qui reçoit des signaux représentatifs de la tension secondaire $u_2$. La sortie du bloc sommateur 9 est connectée à l'entrée du bloc intégrateur 7 par l'intermédiaire d'un quatrième bloc multiplicateur 10, représenté sous la forme d'un bloc amplificateur, de gain $1/n_2$, en série avec un bloc inverseur 11. On peut vérifier que la grandeur ainsi obtenue à la sortie du bloc intégrateur 7 et appliquée sur la seconde entrée du bloc 4 est représentative du flux magnétique $\varnothing_2$.

Pour obtenir une détermination du courant pri-

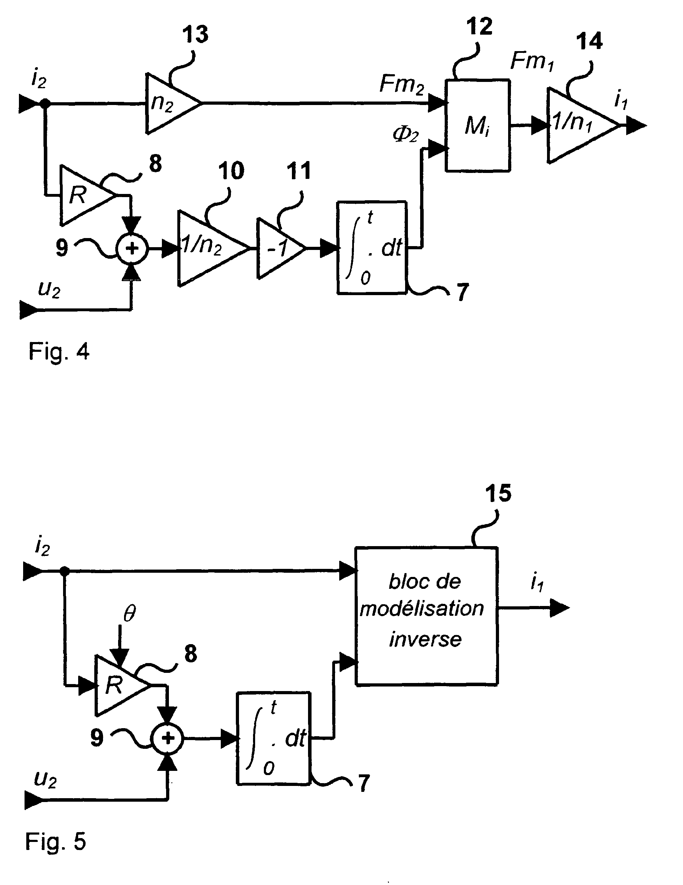

maire $i_1$, le schéma de modélisation directe peut être inversé. On utilise le schéma de modélisation inverse illustré à la figure 4, sous forme de schéma-bloc. Celui-ci permet de déterminer les valeurs instantanées du courant primaire $i_1$ à partir des mesures instantanées du courant secondaire $i_2$ et de la tension secondaire $u_2$. Ce modèle se distingue du précédent en ce qu'il comporte un bloc 12, représentatif d'un modèle inverse ($M_i$) de transformateur. Une première entrée du bloc 12 est connectée à une première entrée du schéma de modélisation inverse, recevant des signaux représentatifs du courant secondaire $i_2$, par l'intermédiaire d'un cinquième bloc multiplicateur 13, représenté sous la forme d'un bloc amplificateur, de gain $n_2$ et fournissant une grandeur représentative de la force magnétomotrice $Fm_2$. Une seconde entrée du bloc 12 est connectée à la sortie du bloc intégrateur 7, fournissant, comme sur la figure 3, une grandeur représentative du flux magnétique $\varnothing_2$, formée à partir des signaux $i_2$ et $u_2$ appliqués à des première et seconde entrées du schéma de modélisation inverse, à l'aide des blocs 7, 8, 9, 10 et 11. La sortie du bloc 12, représentative de la force magnétomotrice $Fm_1$, est connectée à la sortie du schéma de modélisation inverse par l'intermédiaire d'un sixième bloc multiplicateur 14, représenté sous la forme d'un bloc amplificateur de gain $1/n_1$. Le modèle inverse de base ($M_i$) repose sur l'existence d'une fonction F telle que :

$$Fm_1 = F\left(\varnothing_2, Fm_2\right).$$

Dans un mode de réalisation préférentiel du schéma de modélisation inverse représenté à la figure 5, les blocs multiplicateurs et inverseurs 10, 11, 13 et 14 sont intégrés dans un bloc de modélisation inverse 15. Dans un premier mode de réalisation d'un dispositif selon l'invention, un même enroulement secondaire de $n_2$ spires (figure 1) fournit à des premières et secondes entrées de l'ensemble de traitement numérique les valeurs instantanées du courant secondaire $i_2$ et de la tension secondaire $u_2$. L'ensemble de traitement numérique comporte le bloc de modélisation inverse 15 ayant une première entrée recevant les valeurs instantanées du courant secondaire $i_2$. Le bloc sommateur 9 est connecté d'une part à la seconde entrée de l'ensemble du traitement numérique, recevant la tension secondaire $u_2$, et d'autre part à la première entrée de l'ensemble du traitement numérique par l'intermédiaire du troisième bloc multiplicateur 8. Une seconde entrée du bloc de modélisation inverse 15 est connectée à la sortie du bloc intégrateur 7, dont l'entrée est connectée à la sortie du bloc sommateur 9. La sortie du bloc de modélisation inverse 15 constitue la sortie de l'ensemble de traitement numérique, fournissant les valeurs instantanées du courant primaire $i_1$ associées aux valeurs $i_2$ et $u_2$ mesurées.

Dans le transformateur de courant, la résistance R de l'enroulement secondaire peut varier de manière importante en fonction de la température. A titre d'exemple la variation de résistance peut être de l'ordre de 40 % dans la gamme de températures acceptées dans le cas d'un disjoncteur.

Dans un mode de réalisation préférentiel, l'ensemble de traitement numérique comporte des moyens de compensation des variations de température de l'enroulement secondaire. Sur la figure 5, ces moyens de compensation sont représentés sous la forme d'une entrée de réglage du gain du bloc 8 en fonction de la température $\varnothing$, qui peut être mesurée par tout moyen approprié. Les caractéristiques de variation de la résistance R de l'enroulement secondaire en fonction de la température étant connues, la valeur du gain R est modifiée en fonction de la température mesurée.

Pour écarter ce problème de variation de résistance, il est également possible de réaliser l'enroulement secondaire du transformateur en un matériau dont la résistivité est sensiblement indépendante de la température, par exemple en constantan.

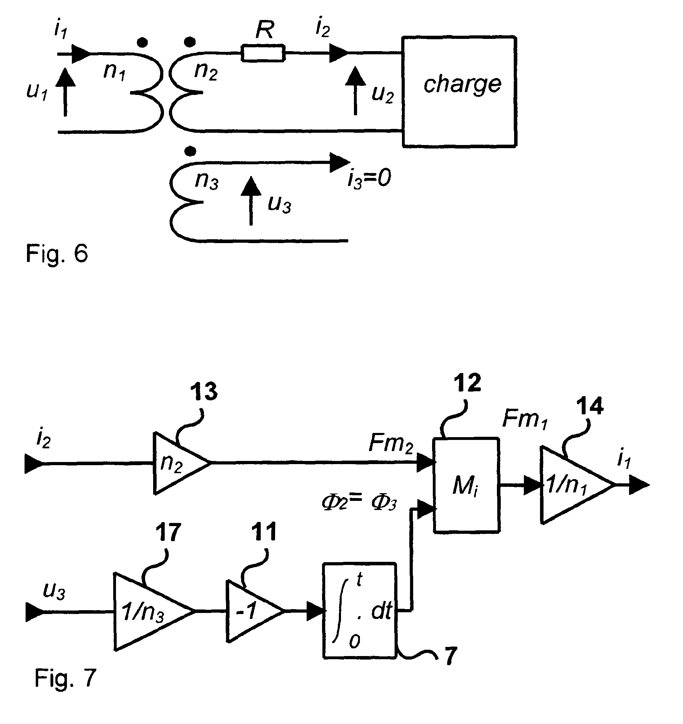

Une autre solution à ce problème est fournie par le mode de réalisation représenté aux figures 6 à 8 utilisant deux enroulements secondaires du transformateur. Un premier enroulement secondaire, de résistance R et comportant $n_2$ spires, fournit, comme précédemment les valeurs instantanées du courant secondaire $i_2$. Il est normalement connecté (figure 6) à une charge 16, aux bornes de laquelle se développe une tension $u_2$. Un second enroulement secondaire, ouvert, comportant $n_3$ spires, fournit une tension secondaire $u_3$ destinée à être appliquée à la seconde entrée de l'ensemble de traitement numérique. Le second enroulement secondaire étant ouvert, il n'est parcouru par aucun courant ($i_3 = 0$). Le second enroulement secondaire est disposé autour du premier enroulement secondaire, de manière à être traversé par le même flux magnétique $\varnothing_3 = \varnothing_2$. Comme représenté à la figure 7, la tension secondaire $u_3$ mesurée aux bornes du second enroulement secondaire, peut alors être utilisée pour reconstituer la grandeur d'entrée représentative du flux magnétique secondaire, $\varnothing_2 = \varnothing_3$ appliquée à l'entrée du bloc 12. Pour cela, un septième bloc multiplicateur 17, représenté sous la forme d'un bloc amplificateur de gain $1/n_3$, est disposé en série avec le bloc inverseur 11 et le bloc intégrateur 7. La résistance du premier enroulement secondaire n'a plus à être pris en compte pour la détermination du flux magnétique et la résistance du second enroulement secondaire n'a pas d'influence. En effet, le second enroulement secondaire n'étant pas traversé par un courant ($i_3 = 0$), il ne produit pas de force magnétomotrice $Fm_3$.

Le second enroulement secondaire peut être réalisé avec du fil très fin et son nombre de spires $n_3$ peut être relativement faible par rapport au nombre de spires $n_2$ du premier enroulement secondaire. La place occupée par le second enroulement secondaire peut donc être très réduite.

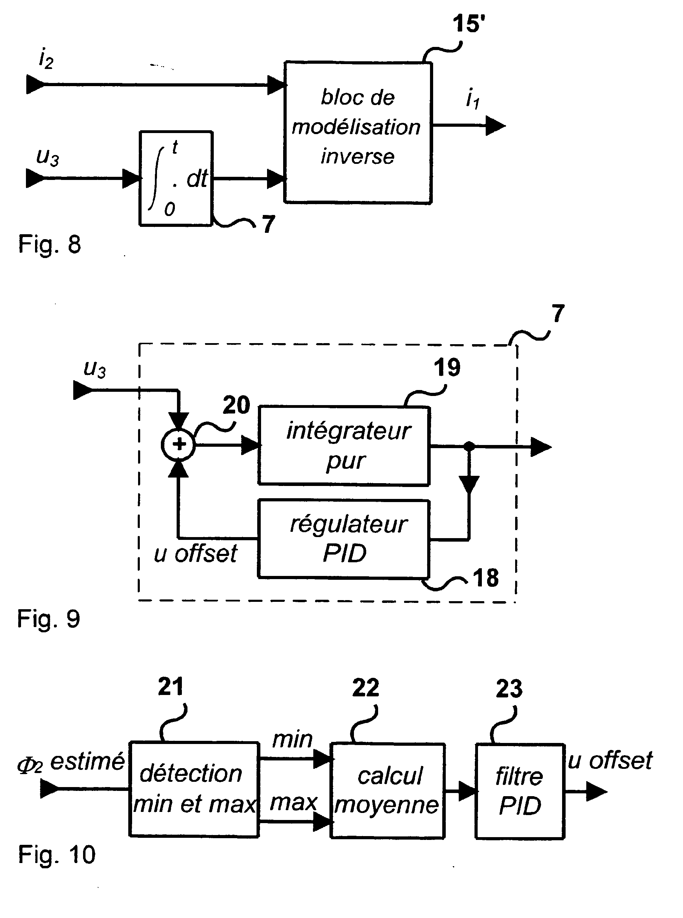

De manière analogue à la figure 5, dans un autre mode de réalisation préférentiel représenté à la figure 8, les blocs multiplicateurs et inverseurs 11, 13, 14 et 17 de la figure 7 peuvent être intégrés dans un bloc de modélisation inverse 15'.

Dans les schémas de modélisation des figures 3, 4 et 7, ainsi que dans les modes de réalisation des figures 5 et 8, les blocs 4, 12, 15 et 15' sont, de préférence, constitués par des tables numériques, à deux entrées et une sortie, dont le contenu est obtenu, par interpolation, à partir de mesures effectuées préalablement sur un prototype de transformateur de courant.

Les tables numériques peuvent être obtenues, à partir de mesures, par toute méthode en utilisant en particulier successivement des méthodes connues de lissage, de triangulation (par exemple en utilisant le critère de Delaunay), d'interpolation, en exploitant la propriété de symétrie centrale de la fonction F, et enfin de simulation et de test.

Dans un mode de réalisation des figures 6 à 8, il a été supposé ci-dessus que le couplage entre les deux enroulements secondaires est idéal, c'est-à-dire que le même flux magnétique traverse les deux enroulements secondaires. Le dispositif selon l'invention reste applicable même si ce couplage n'est pas idéal. Bien entendu les valeurs du bloc de modélisation inverse 15' doivent alors être calculées en conséquence. En effet, on peut montrer que le second enroulement secondaire est alors traversé par un flux $\varnothing_3$, qui bien que différent de $\varnothing_2$, dépend d'un point de fonctionnement défini par $\varnothing_2$ et $Fm_2$, la force magnétomotrice $Fm_3$ associée au second enroulement secondaire étant nulle car celui-ci est en circuit ouvert ($i_3 = 0$). Il existe alors une fonction G telle que : $\varnothing_3 = G (\varnothing_2, Fm_2)$ et il devient possible d'exprimer $\varnothing_2$ en fonction de $\varnothing_3$ et $Fm_2$ et, en conséquence, $Fm_1$ en fonction de $\varnothing_3$ et $Fm_2$. Les essais menant à la détermination des valeurs à introduire dans le bloc de modélisation inverse 15', doivent alors tenir compte de ces caractéristiques et utiliser un prototype dans lequel le couplage entre les deux enroulements secondaires est prédéterminé, même s'il n'est pas idéal.

L'utilisation d'un modèle inverse de transformateur prenant en compte non seulement le courant secondaire, mais également le flux magnétique secondaire, par intégration de la tension secondaire mesurée, permet ainsi une détermination du courant primaire à partir de mesures du courant et de la tension secondaires même lorsque le transformateur de courant est saturé, quelle que soit la forme du courant. A titre d'exemple, le dispositif selon l'invention fournit avec une bonne précision les valeurs d'un courant primaire ayant la forme de signaux carrés de forte amplitude impliquant une saturation du transformateur de courant. De même, les mesures de compensation des variations de température ont permis d'obtenir des résultats corrects même avec un doublement de la résistance de l'enroulement secondaire en fonction des conditions de température.

Cependant, le dispositif décrit peut poser des problèmes lorsqu'une tension d'offset continue, même faible, est présente aux bornes de l'enroulement secondaire. En effet, les signaux $u_2$ ou $u_3$, ainsi que les signaux $i_2$ dans le cas où un seul enroulement secondaire est utilisé (figures 1 à 5), étant intégrés dans le bloc intégrateur 7, la présence d'une telle tension d'offset tend à faire diverger la valeur du flux magnétique en sortie du bloc intégrateur et, en conséquence, la valeur estimée du courant primaire $i_1$ à déterminer. Pour surmonter ce problème, la sortie du bloc intégrateur est stabilisée par tout moyen approprié. A titre d'exemple, les moyens de stabilisation du bloc intégrateur peuvent comporter un circuit régulateur de type PID (proportionnel - intégral - dérivé) comme représenté à la figure 9. Sur cette figure, le bloc intégrateur 7 comporte un circuit intégrateur 19, un circuit régulateur 18 de type PID, disposé entre la sortie du circuit intégrateur 19 et une entrée d'un circuit sommateur 20, qui reçoit sur une autre entrée le signal d'entrée, $u_3$ sur la figure 9, du bloc intégrateur et dont la sortie est connectée à l'entrée du circuit intégrateur 19. Le fonctionnement de ce type de moyens de stabilisation est bien connu et ne sera pas décrit plus en détail. A titre d'exemple, la figure 10 illustre un mode de réalisation préférentiel du circuit régulateur 18 de la figure 9. Celui-ci comporte, en série, de manière connue, un circuit 21 de détection des minimum et des maximum, un circuit 22 de calcul des moyennes et un filtre 23 du type PID, de manière à fournir en sortie une valeur de la tension d'offset u offset.

L'invention n'est en aucune manière limitée aux moyens de stabilisation décrits aux figures 9 et 10. A titre d'exemple, ces moyens de stabilisation peuvent être constitués par un intégrateur court terme.

**Revendications**

1. Dispositif de détermination du courant primaire d'un transformateur de courant, comportant des moyens de traitement numérique ayant une première entrée recevant des valeurs instantanées mesurées du courant secondaire ($i_2$) du transformateur et une sortie fournissant les valeurs instantanées du courant primaire ($i_1$) associé, corrigées en cas de saturation du transformateur, dispositif **caractérisé en ce que** les moyens de traitement numérique comportent une seconde entrée recevant une tension ($u_2$, $u_3$) secondaire mesurée aux bornes d'un enroulement secondaire du transformateur de courant et connectée à l'entrée de moyens intégrateurs (7) fournissant des signaux représentatifs du flux magnétique ($\varnothing_2$, $\varnothing_3$) instantané dans le secondaire du transformateur, des moyens de modélisation (12, 15, 15'), représentatifs d'un modèle inverse du transformateur de courant et comportant des première et seconde entrées et une sortie, la première entrée des moyens de modélisation (12, 15, 15') étant connectée à la première entrée des moyens de traitement numérique , la seconde entrée des moyens de modélisation (12, 15, 15') étant connectée à la sortie des moyens intégrateurs (7) et la sortie des moyens de modélisation étant connectée à la sortie des moyens de traitement numérique.

2. Dispositif selon la revendication 1, **caractérisé en ce que** les moyens de modélisation comportent une table numérique à deux entrées.

3. Dispositif selon l'une des revendications 1 et 2, **caractérisé en ce que** le transformateur comporte un premier enroulement secondaire, fournissant les valeurs instantanées du courant secondaire ($i_2$), et un second enroulement secondaire, ouvert, disposé autour du premier enroulement secondaire et fournissant la tension secondaire ($u_3$) appliquée à la seconde entrée des moyens de traitement.

4. Dispositif selon l'une des revendications 1 et 2, **caractérisé en ce que** le transformateur comporte un enroulement secondaire fournissant les valeurs instantanées du courant secondaire ($i_2$) et de la tension secondaire ($u_2$), les moyens de traitement numérique comportant des moyens multiplicateurs (8) connectés à la première entrée des moyens numériques de traitement pour multiplier le courant secondaire ($i_2$) par une grandeur représentative de la résistance (R) du secondaire du transformateur de courant, des moyens sommateurs (9) connectés à la sortie des moyens multiplicateurs (8) et à la seconde entrée des moyens de traitement numérique, la sortie des moyens sommateurs (9) étant connectée à l'entrée des moyens intégrateurs (7).

5. Dispositif selon la revendication 4, **caractérisé en ce que** les moyens de traitement numérique comportent des moyens de compensation des variations de température de l'enroulement secondaire.

6. Dispositif selon la revendication 4, **caractérisé en ce que** l'enroulement secondaire du transformateur est en un matériau dont la résistivité est sensiblement indépendante de la température.

7. Dispositif selon la revendication 6, **caractérisé en ce que** le matériau est du constantan.

8. Dispositif selon l'une quelconque des revendications 1 à 7, **caractérisé en ce que** les moyens intégrateurs (7) comportent des moyens de stabilisation (18,20).

9. Dispositif selon la revendication 8, **caractérisé en ce que** les moyens de stabilisation comportent des moyens de régulation de type PID (18).

**Claims**

1. Device for determining the primary current of a current transformer, comprising digital processing means having a first input receiving measured instantaneous values of the secondary current ($i_2$) of the transformer and an output supplying the instantaneous values of the associated primary current ($i_1$), corrected in case of saturation of the transformer, device **characterized in that** the digital processing means comprise a second input receiving a secondary voltage ($u_2$, $u_3$) measured at the terminals of a secondary winding of the current transformer and connected to the input of integrating means (7) supplying signals representative of the instantaneous magnetic flux ($\varnothing_2$, $\varnothing_3$) in the secondary winding of the transformer, modelling means (12, 15, 15') representative of an inverse model of the current transformer and comprising first and second inputs and an output, the first input of the modelling means (12, 15, 15') being connected to the first input of the digital processing means, the second input of the modelling means (12, 15, 15') being connected to the output of the integrating means (7) and the output of the modelling means being connected to the output of the digital processing means.

2. Device according to claim 1, **characterized in that** the modelling means comprise a numerical table with two inputs.

3. Device according to one of claims 1 and 2, **characterized in that** the transformer comprises a first secondary winding supplying the instantaneous values of the secondary current ($i_2$), and a second, open, secondary winding arranged around the first secondary winding and supplying the secondary voltage ($u_3$) applied to the second input of the processing means.

4. Device according to one of claims 1 and 2, **characterized in that** the transformer comprises a secondary winding supplying the instantaneous values of the secondary current ($i_2$) and of the secondary voltage ($u_2$), the digital processing means comprising multiplying means (8) connected to the first input of the digital processing means to multiply the secondary current ($i_2$) by a quantity representative of the resistance (R) of the secondary winding of the current transformer, summing means (9) connected to the output of the multiplying means (8) and to the second input of the digital processing means, the output of the summing means (9) being connected to the input of the integrating means (7).

5. Device according to claim 4, **characterized in that** the digital processing means comprise means for compensating the temperature variations of the secondary winding.

6. Device according to claim 4, **characterized in that** the secondary winding of the transformer is made of a material having a resistivity that is appreciably independent from the temperature.

7. Device according to claim 6, **characterized in that** the material is constantan.

8. Device according to any one of claims 1 to 7, **characterized in that** the integrating means (7) comprise stabilizing means (18, 20).

9. Device according to claim 8, **characterized in that** the stabilizing means comprise PID type regulating means (18).

**Patentansprüche**

1. Anordnung zur Bestimmung des Primärstroms eines Stromwandlers, welche Anordnung Digitalverarbeitungsmittel mit einem, gemessene Augenblickswerte des Sekundärstroms ($i_2$) des Stromwandlers empfangenden ersten Eingang sowie mit einem Ausgang umfasst, der die, bei Sättigung des Stromwandlers korrigierten, Augenblickswerte des zugehörigen Primärstroms ($i_1$) liefert, **dadurch gekennzeichnet, dass** die Digitalverarbeitungsmittel einen zweiten Eingang, der eine an den Klemmen einer Sekundärwicklung des Stromwandlers gemessene Sekundärspannung ($u_2$, $u_3$) empfängt und mit dem Eingang von Integriermitteln (7) verbunden ist, welche den Augenblickswert des magnetischen Flusses ($\varnothing_2$, $\varnothing_3$) in der Sekundärwicklung des Stromwandlers abbildende Signale liefern, sowie ein Inversmodell des Stromwandlers abbildende Modelliermittel (12, 15, 15') mit einem ersten und einem zweiten Eingang sowie mit einem Ausgang umfassen, wobei der erste Eingang der Modelliermittel (12, 15, 15') mit dem ersten Eingang der Digitalverarbeitungsmittel, der zweite Eingang der Modelliermittel (12, 15, 15') mit dem Ausgang der Integriermittel (7) und der Ausgang der Modelliermittel mit dem Ausgang der Digitalverarbeitungsmittel verbunden ist.

2. Anordnung nach Anspruch 1, **dadurch gekennzeichnet, dass** die Modelliermittel eine Wertematrix mit zwei Eingängen umfasst.

3. Anordnung nach einem der Ansprüche 1 und 2, **dadurch gekennzeichnet, dass** der Stromwandler eine die Augenblickswerte des Sekundärstroms ($i_2$) liefernde erste Sekundärwicklung sowie eine offene zweite Sekundärwicklung umfasst, die um die erste Sekundärwicklung herum angeordnet ist und die an den zweiten Eingang der Verarbeitungsmittel angelegte Spannung ($u_3$) liefert.

4. Anordnung nach einem der Ansprüche 1 und 2, **dadurch gekennzeichnet, dass** der Stromwandler eine die Augenblickswerte des Sekundärstroms ($i_2$) und der Sekundärspannung ($u_2$) liefernde Sekundärwicklung umfasst, wobei die Digitalverarbeitungsmittel mit dem ersten Eingang der Digitalverarbeitungsmittel verbundene Multipliziermittel (8) zur Multiplikation des Sekundärstroms ($i_2$) mit einer den Widerstand (R) der Sekundärwicklung des Stromwandlers abbildenden Größe sowie mit dem Ausgang der Multipliziermittel (8) und dem zweiten Eingang der Digitalverarbeitungsmittel verbundene Addiermittel (9) umfassen und der Ausgang der Addiermittel (9) mit dem Eingang der Integriermittel (7) verbunden ist.

5. Anordnung nach Anspruch 4, **dadurch gekennzeichnet, dass** die Digitalverarbeitungsmittel Kompensationsmittel zum Ausgleich der Temperaturänderungen der Sekundärwicklung umfassen.

6. Anordnung nach Anspruch 4, **dadurch gekennzeichnet, dass** die Sekundärwicklung des Stromwandlers aus einem Material besteht, dessen spezifischer Widerstand annähernd unabhängig von der Temperatur ist.

7. Anordnung nach Anspruch 6, **dadurch gekennzeichnet, dass** das Material Konstantan ist.

8. Anordnung nach irgendeinem der Ansprüche 1 bis 7, **dadurch gekennzeichnet, dass** die Integriermittel (7) Stabilisierungsmittel (18, 20) umfassen.

9. Anordnung nach Anspruch 8, **dadurch gekennzeichnet, dass** die Stabilisierungsmittel Regelungsmittel vom Typ PID (18) umfassen.

Fig. 1

Fig. 2

Fig. 3

Fig. 4

Fig. 5

Fig. 6

Fig. 7

**15'**

$i_2$ →

$u_3$ → $\int_0^t \cdot dt$ → **7**

→ bloc de modélisation inverse → $i_1$

**Fig. 8**

**7**

$u_3$ →

(+) **20**

**19** intégrateur pur

régulateur PID **18**

$u$ offset

**Fig. 9**

**21**　　**22**　　**23**

$\Phi_2$ estimé → détection min et max → min / max → calcul moyenne → filtre PID → $u$ offset

**Fig. 10**

**RÉFÉRENCES CITÉES DANS LA DESCRIPTION**

**Documents brevets cités dans la description**

- WO 9313581 A
- EP 980129 A